(19) Europäisches Patentamt
European Patent Office
Office européen des brevets

(11) **EP 4 693 117 A1**

(12) **EUROPEAN PATENT APPLICATION**

(43) Date of publication:
**11.02.2026 Bulletin 2026/07**

(21) Application number: **25188024.1**

(22) Date of filing: **08.07.2025**

(51) International Patent Classification (IPC):
*G06N 10/40* (2022.01)

(52) Cooperative Patent Classification (CPC):
**G06N 10/40**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **08.08.2024 JP 2024131790**

(71) Applicant: **FUJITSU LIMITED
Kawasaki-shi, Kanagawa 211-8588 (JP)**

(72) Inventor: **SEKINE, Akihiko
Kawasaki-shi, 211-8588 (JP)**

(74) Representative: **Haseltine Lake Kempner LLP
Cheapside House
138 Cheapside
London EC2V 6BJ (GB)**

(54) **QUANTUM TRANSDUCER AND QUANTUM TRANSDUCTION METHOD**

(57)     A quantum transducer includes a three-dimensional cavity resonator; a stack disposed in the three-dimensional cavity resonator, including a nonmagnetic first insulator film and a ferromagnetic or antiferromagnetic second insulator film that are stacked on each other, and having an interface between the first insulator film and the second insulator film; a magnetic field applicator configured to apply, to the stack, a magnetic field having a component perpendicular to the interface; and a microwave transceiver configured to transmit and receive a microwave to and from the stack. The first insulator film and the second insulator film do not include a topological insulator. The second insulator film has an easy axis of magnetization along a first axis that is perpendicular to the interface. Laser light is emitted to the stack from a direction inclined with respect to the first axis.

FIG.1

**Description**

FIELD

The present disclosure relates to a quantum transducer and a quantum transduction method.

BACKGROUND

In quantum computers, quantum transduction between microwave photons and optical photons is often performed. Further, quantum transducers including topological insulators have been proposed.
In such a quantum transducer including a topological insulator, transduction efficiency can be improved, but the frequencies of light that can be used are limited, and loss of the light in an optical fiber is large.
An object of the present disclosure is to provide a quantum transducer and a quantum transduction method, in which transduction efficiency can be improved even when light with low loss in an optical fiber is used.

RELATED-ART DOCUMENTS

PATENT DOCUMENTS

[Patent Document 1] Japanese Laid-open Patent Publication No. 2023-546863
[Patent Document 2] Japanese Laid-open Patent Publication No. 2022-538247
[Patent Document 3] U.S. Patent Application Publication No. 2021/0114864
[Patent Document 4] U.S. Patent Application Publication No. 2020/0412457

SUMMARY

According to an embodiment of the present disclosure, a quantum transducer includes a three-dimensional cavity resonator; a stack disposed in the three-dimensional cavity resonator, including a nonmagnetic first insulator film and a ferromagnetic or antiferromagnetic second insulator film that are stacked on each other, and having an interface between the first insulator film and the second insulator film; a magnetic field applicator configured to apply, to the stack, a magnetic field having a component perpendicular to the interface; and a microwave transceiver configured to transmit and receive a microwave to and from the stack. The first insulator film and the second insulator film do not include a topological insulator. The second insulator film has an easy axis of magnetization along a first axis that is perpendicular to the interface. Laser light is emitted to the stack from a direction inclined with respect to the first axis.
According to an embodiment of the present disclosure, transduction efficiency can be improved even when light with low loss in an optical fiber is used.

BRIEF DESCRIPTION OF DRAWINGS

FIG. 1 is a schematic view illustrating a quantum transducer according to a first embodiment;
FIG. 2 is a schematic diagram illustrating the theory of quantum transduction by the quantum transducer according to the first embodiment;
FIG. 3 is a graph illustrating the relationship between the number of second insulator films and transduction efficiency according to the first embodiment;
FIG. 4 is a graph illustrating the relationship between a thickness parameter and transduction efficiency according to the first embodiment;
FIG. 5 is a schematic view illustrating a quantum transducer according to a second embodiment;
FIG. 6 is a schematic view illustrating a quantum transducer according to a third embodiment;
FIG. 7 is a schematic diagram illustrating the theory of quantum transduction by the quantum transducer according to the third embodiment;
FIG. 8 is a graph illustrating the relationship between the number of second insulator films and transduction efficiency according to the third embodiment;
FIG. 9 is a graph illustrating the relationship between a thickness parameter and transduction efficiency according to the third embodiment; and

FIG. 10 is a schematic view illustrating a quantum transducer according to a fourth embodiment.

DESCRIPTION OF EMBODIMENTS

In the following, embodiments of the present disclosure will be described in detail with reference to the accompanying drawings. In the specification and the drawings, components having substantially the same functional configuration are denoted by the same reference numeral, and a redundant description thereof may be omitted.

(First Embodiment)

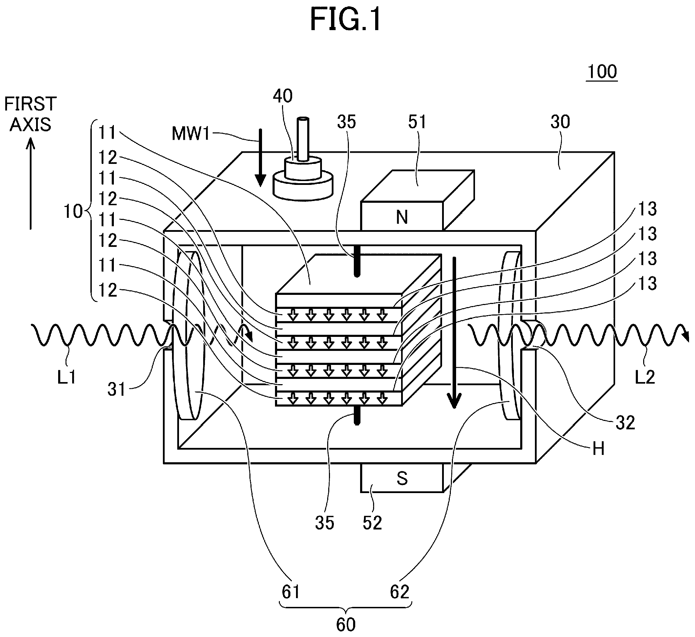

A first embodiment will be described. The first embodiment relates to a quantum transducer. The quantum transducer according to the first embodiment converts microwave photons into optical photons. FIG. 1 is a schematic view illustrating the quantum transducer according to the first embodiment.

As illustrated in FIG. 1, a quantum transducer 100 according to the first embodiment includes a microwave resonator 30, a stack 10 an N-pole 51, an S-pole 52, an antenna 40, and an optical resonator 60.

The microwave resonator 30 includes an inlet 31 and an outlet 32. The stack 10 is fixed to the inside of the microwave resonator 30 by a support member 35. An optical fiber is connected to the inlet 31, laser light L1 is introduced from the outside through the inlet 31, and the laser light L1 is emitted toward the stack 10. The optical fiber is connected to the outlet 32, and laser light L2 transmitted through the stack 10 is guided to the outside through the outlet 32. Each of the laser light L1 and the laser light L2 is circularly polarized laser light. The microwave resonator 30 is an example of a three-dimensional cavity resonator.

The optical resonator 60 includes a first mirror 61 and a second mirror 62. The first mirror 61 is provided between the inlet 31 and the stack 10, and the second mirror 62 is provided between the outlet 32 and the stack 10. The optical resonator 60 amplifies the circularly polarized laser light.

The stack 10 includes first insulator films 11 and second insulator films 12 that are alternately stacked. Each of the first insulator films 11 contacts a corresponding one of the second insulator films 12, and the stack 10 includes interfaces 13 between the first insulator films 11 and the second insulator films 12. The first insulator films 11 and the second insulator films 12 do not include topological insulators.

Each of the first insulator films 11 is a nonmagnetic insulator film and does not include a topological insulator. For example, each of the first insulator films 11 includes $SrTiO_3$, $Al_2O_3$, or both. The relative permeability of the first insulator films 11 is 1.02 or less.

The second insulator films 12 are ferromagnetic insulator films. Each of the second insulator films 12 has an easy axis of magnetization along a first axis that is perpendicular to the interfaces 13. The laser light L1 and the laser light L2 have components perpendicular to easy axes of magnetization of ferromagnetic insulators included in the second insulator films 12. For example, each of the second insulator films 12 includes $Y_3Fe_5O_{12}$ (YIG), $Tm_3Fe_5O_{12}$ (TIG), EuS, $Cr_2Ge_2Te_6$, $BaFe_{12}O_{19}$, or any combination thereof. In FIG. 1, arrows in the second insulator films 12 indicate the directions of spins in the ferromagnetic insulators.

The N-pole 51 and the S-pole 52 are provided on outer wall surfaces of the microwave resonator 30. A magnetic field H directed from the N-pole 51 to the S-pole 52 is generated between the N-pole 51 and the S-pole 52. The N-pole 51 and the S-pole 52 serve as a magnetic field applicator configured to apply, to the stack 10, the magnetic field H having a component parallel to the first axis.

The antenna 40 is provided on the outer wall surface of the microwave resonator 30. The antenna 40 serves as a microwave transceiver configured to transmit and receive a microwave to and from the stack 10. In the present embodiment, the antenna 40 transmits, to the stack 10, a microwave MW1 input from the outside.

The polarization and the like of the laser light L2 guided to the outside through the outlet 32 are detected. In this manner, microwave photons of the microwave MW1 emitted to the stack 10 through the antenna 40 are converted into optical photons. That is, a quantum transduction method using the quantum transducer 100 includes a process of emitting the laser light L1 to the stack 10 from a direction inclined with respect to the first axis. For example, microwave photons with frequencies of about 1 GHz to 100 GHz are converted into optical photons with a frequency of about 200 THz.

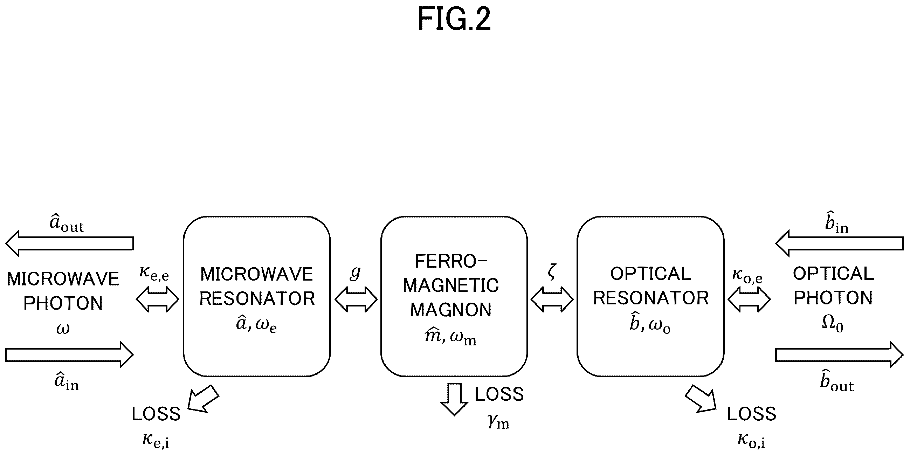

The theory of quantum transduction by the quantum transducer 100 will be described. FIG. 2 is a schematic diagram illustrating the theory of quantum transduction by the quantum transducer 100 according to the first embodiment. Parameters in FIG. 2 represent items illustrated in Table 1.

[Table 1]

| | |
|---|---|
| $\hat{a}_{in}$ : | ANNIHILATION OPERATOR OF ITINERANT MICROWAVE PHOTONS (INPUT) |
| $\hat{a}_{out}$ : | ANNIHILATION OPERATOR OF ITINERANT MICROWAVE PHOTONS (OUTPUT) |
| $\hat{b}_{in}$ : | ANNIHILATION OPERATOR OF ITINERANT OPTICAL PHOTONS (INPUT) |

(continued)

| | |
|---|---|
| $\hat{b}_{\text{out}}$ : | ANNIHILATION OPERATOR OF ITINERANT OPTICAL PHOTONS (OUTPUT) |
| $\hat{a}$ : | ANNIHILATION OPERATOR OF PHOTONS IN MICROWAVE RESONATOR |
| $\hat{b}$ : | ANNIHILATION OPERATOR OF PHOTONS IN OPTICAL RESONATOR |
| $\hat{m}_{\alpha}, \hat{m}_{\beta}$ : | ANNIHILATION OPERATOR OF FERROMAGNETIC MAGNONS |
| $\omega_e$ : | RESONANT FREQUENCY OF MICROWAVE RESONATOR |
| $\omega_m$ : | RESONANT FREQUENCY OF FERROMAGNETIC INSULATORS |
| $\omega_o$ : | RESONANT FREQUENCY OF OPTICAL RESONATOR |
| $\omega$ : | FREQUENCY OF ITINERANT MICROWAVE PHOTONS |
| $\Omega_0$ : | FREQUENCY OF ITINERANT OPTICAL PHOTONS |
| $\kappa_{e,e}$ : | INTERACTION BETWEEN ITINERANT MICROWAVE PHOTONS AND PHOTONS IN MICROWAVE RESONATOR |
| $\kappa_{e,i}$ : | DISSIPATION RATE OF MICROWAVE RESONATOR |
| $g$ : | INTERACTION BETWEEN PHOTONS IN MICROWAVE RESONATOR AND FERROMAGNETIC MAGNONS |
| $\gamma_m$ : | DISSIPATION RATE OF FERROMAGNETIC MAGNONS (FERROMAGNETIC RESONANCE STATE) |
| $\zeta$ : | INTERACTION BETWEEN PHOTONS IN OPTICAL RESONATOR AND FERROMAGNETIC MAGNONS |
| $\kappa_{o,i}$ : | DISSIPATION RATE OF OPTICAL RESONATOR |
| $\kappa_{o,e}$ : | INTERACTION BETWEEN ITINERANT OPTICAL PHOTONS AND PHOTONS IN OPTICAL RESONATOR |

The interaction $\zeta$ between photons in the optical resonator 60 and ferromagnetic magnons is represented by equation (1), and the interaction g between photons in the microwave resonator 30 and the ferromagnetic magnons is represented by equation (2).

[Math. 1]

$$\zeta = \zeta_0 \sqrt{N_{\text{L}}/D_{\gamma}} \qquad (1)$$

$$g = g_0 \sqrt{D_{\gamma} N_{\text{L}}} \qquad (2)$$

In the equations (1) and (2), $N_L$ represents the number of the second insulator films 12. In the equation (1), $\zeta_0$ represents the strength of the interaction when each of the second insulator films 12 is a single-layer film having a volume of 1 mm$^3$. In the equation (2), $g_0$ represents the strength of the interaction when each of the second insulator films 12 is a single-layer film having a volume of 1 mm$^3$. In the equations (1) and (2), a thickness parameter $D_\gamma$ is a value obtained by dividing the number of spins $N_S$ included in each of the second insulator films 12 by the number of spins $N_{S0}$ included in a case where the volume of each of the second insulator films 12 is 1 mm$^3$.

Transduction efficiency $\eta$ is represented by equation (3). Microwave susceptibility $\chi_e$, magnon susceptibility $\chi_m$, and optical susceptibility $\chi_o$ in the equation (3) are represented by equation (4), equation (5), and equation (6), respectively, and $\delta\omega_o$ is represented by equation (7).

[Math. 2]

$$\eta = \left| \frac{\langle \hat{b}_{\text{out}} \rangle}{\langle \hat{a}_{\text{in}} \rangle} \right|^2$$

$$= \left| \frac{g\zeta \sqrt{\kappa_{\text{e,e}}} \sqrt{\kappa_{\text{o,e}}}}{\zeta^2 \chi_{\text{e}}^{-1} + g^2 \chi_{\text{o}}^{-1} + \chi_{\text{m}}^{-1} \chi_{\text{e}}^{-1} \chi_{\text{o}}^{-1}} \right|^2 \qquad (3)$$

$$\chi_{\text{e}} = \left[ i(\omega - \omega_{\text{e}}) - (\kappa_{\text{e,e}} + \kappa_{\text{e,i}})/2 \right]^{-1} \qquad (4)$$

$$\chi_{\text{m}} = \left[ i(\omega - \omega_{\text{m}}) - \gamma_{\text{m}}/2 \right]^{-1} \qquad (5)$$

$$\chi_{\text{o}} = \left[ i(\omega - \delta\omega_{\text{o}}) - (\kappa_{\text{o,e}} + \kappa_{\text{o,i}})/2 \right]^{-1} \qquad (6)$$

$$\delta\omega_{\text{o}} = \Omega_0 - \omega_{\text{o}} \qquad (7)$$

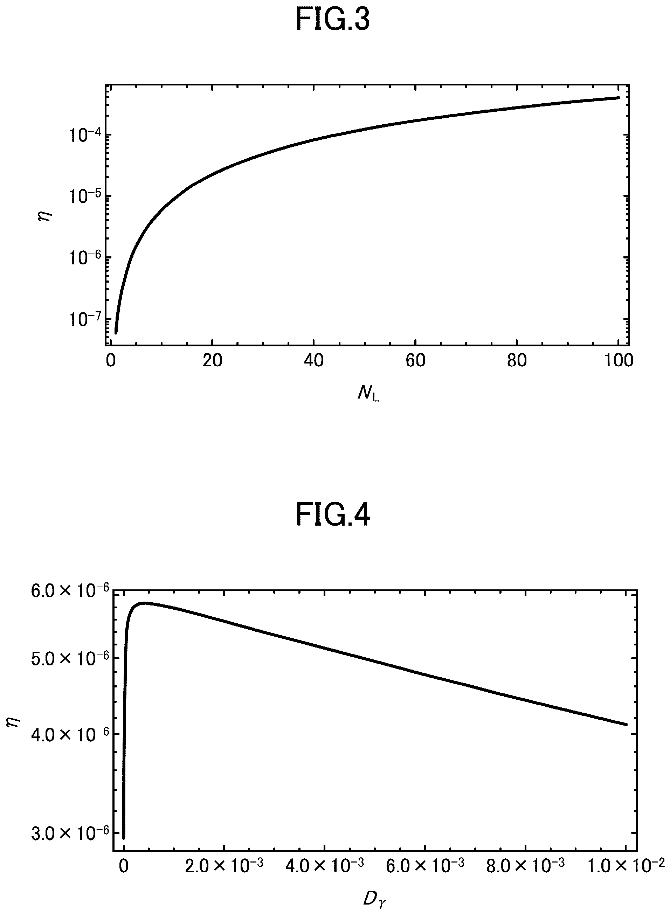

When resonance conditions are satisfied, that is, when the frequency $\omega$ of itinerant microwave photons, the resonant frequency $\omega_{\text{e}}$ of the microwave resonator 30, the resonant frequency $\omega_{\text{m}}$ of the ferromagnetic insulators, and $\delta\omega_{\text{o}}$ are equal to one another, the transduction efficiency $\eta$ changes in accordance with the number $N_{\text{L}}$ of the second insulator films 12 as illustrated in FIG. 3. FIG. 3 is a graph illustrating the relationship between the number $N_{\text{L}}$ of the second insulator films 12 and the transduction efficiency $\eta$ according to the first embodiment. In this manner, the quantum transducer 100 can convert microwave photons of the microwave MW1 into optical photons. Further, in the quantum transducer 100, the transduction efficiency $\eta$ is proportional to the square of the number $N_{\text{L}}$ of the second insulator films 12. Therefore, the transduction efficiency $\eta$ is significantly increased as the number $N_{\text{L}}$ of the second insulator films 12 is increased. In FIG. 3, the thickness parameter $D_{\gamma}$ is 0.001, $\zeta_0/2\pi$ is about 20 kHz, $\gamma/2\pi$ is about 3 MHz, $g_0/2\pi$ is about 20 MHz, $\kappa_{\text{o,e}}/2\pi$ is about 50 MHz, $\kappa_{\text{e,e}}/2\pi$ is about 150 MHz, $\kappa_{\text{o,i}}/2\pi$ is about 1,450 MHz, and $\kappa_{\text{e,i}}/2\pi$ is about 100 MHz.

Further, because the first insulator films 11 and the second insulator films 12 do not include topological insulators, light with a frequency of about 200 THz can be used. That is, light with low loss in optical fiber transmission can be used.

In a case where the number $N_{\text{L}}$ of the second insulator films 12 is constant, the relationship between the thickness parameter $D_{\gamma}$ and the transduction efficiency $\eta$ is as illustrated in FIG. 4. FIG. 4 is a graph illustrating the relationship between the thickness parameter $D_{\gamma}$ and the transduction efficiency $\eta$ according to the first embodiment. As illustrated in FIG. 4, in a range in which the thickness parameter $D_{\gamma}$ is greater than or equal to a certain threshold, the transduction efficiency $\eta$ increases as the thickness parameter $D_{\gamma}$ decreases. The thickness of each of the second insulator films 12 corresponding to the threshold of the thickness parameter $D_{\gamma}$ is about 100 nm. In FIG. 4, the number $N_{\text{L}}$ of the second insulator films 12 is 10, $\zeta_0/2\pi$ is about 20 kHz, $\gamma/2\pi$ is about 3 MHz, $g_0/2\pi$ is about 20 MHz, $\kappa_{\text{o,e}}/2\pi$ is about 50 MHz, $\kappa_{\text{e,e}}/2\pi$ is about 150 MHz, $\kappa_{\text{o,i}}/2\pi$ is about 1,450 MHz, and $\kappa_{\text{e,i}}/2\pi$ is about 100 MHz.

(Second Embodiment)

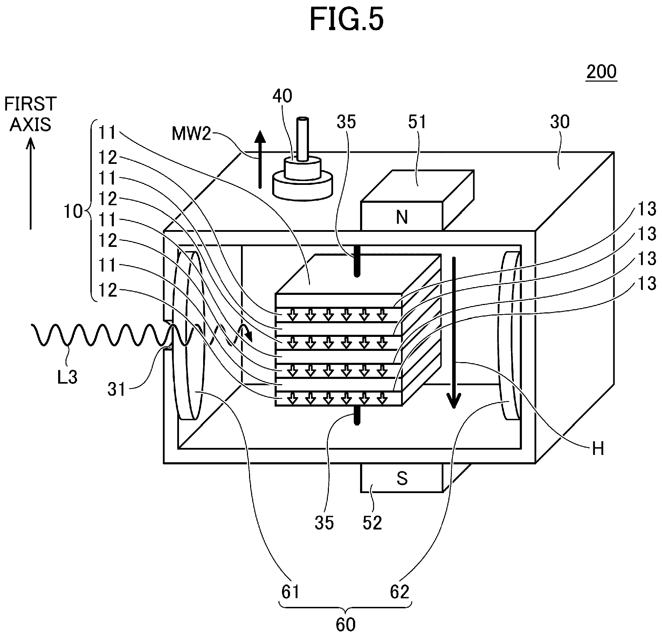

A second embodiment will be described. The second embodiment relates to a quantum transducer. The quantum transducer according to the second embodiment converts optical photons into microwave photons. FIG. 5 is a schematic view illustrating the quantum transducer according to the second embodiment.

As illustrated in FIG. 5, in a quantum transducer 200 according to the second embodiment, laser light L3 is emitted from the outside toward the stack 10 through the inlet 31. The outlet 32 is not necessarily provided. The laser light L3 includes linearly polarized laser light and circularly polarized laser light. The linearly polarized laser light and the circularly polarized laser light have components perpendicular to the easy axes of magnetization of the antiferromagnetic insulators included in the second insulator films 12. The optical resonator 60 amplifies the circularly polarized laser light.

The other configurations of the second embodiment are the same as those of the first embodiment.

In the second embodiment, a microwave MW2 corresponding to the polarization of the laser light L3 is emitted from the stack 10, and the antenna 40 outputs the microwave MW2 to the outside. In this manner, optical photons of the laser light L3 emitted to the stack 10 are converted into microwaves photons of the microwave MW2. That is, a quantum transduction method using the quantum transducer 200 includes a process of emitting the laser light L3 to the stack 10 from a direction inclined with respect to the first axis. For example, optical photons with a frequency of about 200 THz are converted into microwave photons with frequencies of about 1 GHz to 100 GHz.

According to the second embodiment, the same effects as in the first embodiment can be obtained.

(Third Embodiment)

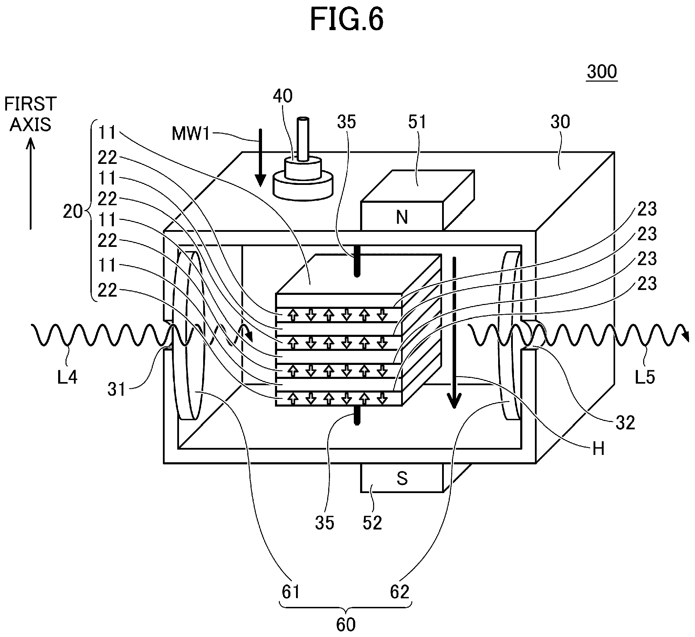

A third embodiment will be described. The third embodiment differs from the first embodiment mainly in the configuration of the stack. FIG. 6 is a schematic view illustrating a quantum transducer according to the third embodiment.

As illustrated in FIG. 6, a quantum transducer 300 according to the third embodiment includes a stack 20 instead of the stack 10.

The stack 20 includes first insulator films 11 and second insulator films 22 that are alternately stacked. Each of the first insulator films 11 contacts a corresponding one of the second insulator films 22, and the stack 20 includes interfaces 23 between the first insulator films 11 and the second insulator films 22. The first insulator films 11 and the second insulator films 22 do not include topological insulators.

The second insulator films 22 are antiferromagnetic insulator films. Each of the second insulator films 22 has an easy axis of magnetization along a first axis that is perpendicular to the interfaces 23. Laser light L4 is emitted from the outside toward the stack 20 through the inlet 31, and laser light L5 transmitted through the stack 20 is guided to the outside through the outlet 32. Each of the laser light L4 and the laser light L5 is circularly polarized laser light. The laser light L4 and the laser light L5 have components perpendicular to easy axes of magnetization of antiferromagnetic insulators included in the second insulator films 22. For example, each of the second insulator films 22 includes $\alpha$-Fe$_2$O$_3$, MnF$_2$, FeF$_2$, NiO, or any combination thereof. In FIG. 6, arrows in the second insulator films 22 indicate the directions of spins in the antiferromagnetic insulators.

The other configurations of the third embodiment are the same as those of the first embodiment.

The polarization and the like of the laser light L5 guided to the outside through the outlet 32 are detected. In this manner, microwave photons of a microwave MW1 emitted to the stack 20 through the antenna 40 are converted into optical photons. That is, a quantum transduction method using the quantum transducer 300 includes a process of emitting the laser light L4 to the stack 20 from a direction inclined with respect to the first axis. For example, microwave photons with frequencies of about 1 GHz to 100 GHz are converted into optical photons with a frequency of about 200 THz.

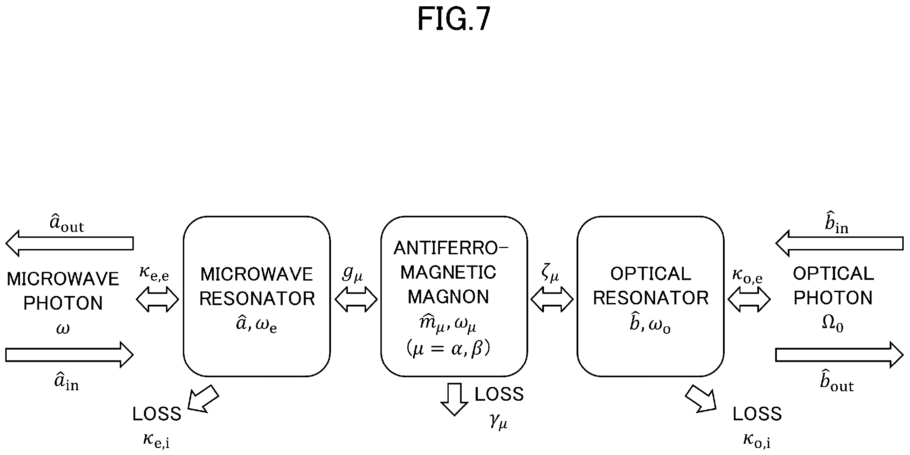

The theory of quantum transduction by the quantum transducer 300 will be described. FIG. 7 is a schematic diagram illustrating the theory of quantum transduction by the quantum transducer 300 according to the third embodiment. Parameters in FIG. 7 represent items illustrated in Table 2.

[Table 2]

| | |
|---|---|
| $\omega_\alpha, \omega_\beta$ : | RESONANT FREQUENCY OF ANTIFERROMAGNETIC INSULATORS |
| $g_\alpha, g_\beta$ : | INTERACTION BETWEEN PHOTONS IN MICROWAVE RESONATOR AND ANTIFERROMAGNETIC MAGNONS |
| $\gamma_\alpha, \gamma_\beta$ : | DISSIPATION RATE OF ANTIFERROMAGNETIC MAGNONS (ANTIFERROMAGNETIC RESONANCE STATE) |
| $\zeta_\alpha, \zeta_\beta$ : | INTERACTION BETWEEN PHOTONS IN OPTICAL RESONATOR AND ANTIFERROMAGNETIC MAGNONS |

The interaction $\zeta_\mu$ between photons in the optical resonator 60 and antiferromagnetic magnons is represented by equation (8), and the interaction $g_\mu$ between photons in the microwave resonator 30 and the antiferromagnetic magnons is represented by equation (9) ($\mu = \alpha, \beta$).

[Math. 3]

$$\zeta_\mu = \zeta_{0,\mu} \sqrt{N_L / D_\gamma} \qquad (8)$$

$$g_\mu = g_{0,\mu} \sqrt{D_\gamma N_L} \qquad (9)$$

In the equations (8) and (9), $N_L$ represents the number of the second insulator films 22. In the equation (8), $\zeta_{0,\mu}$ represents the strength of the interaction when each of the second insulator films 22 is a single-layer film having a volume of 1 mm³. In the equation (9), $g_{0,\mu}$ represents the strength of the interaction when each of the second insulator films 22 is a single-layer film having a volume of 1 mm³. In the equations (8) and (9), a thickness parameter $D_\gamma$ is a value obtained by dividing the number of spins $N_S$ included in each of the second insulator films 22 by the number of spins $N_{S0}$ included in a case where the volume of each of the second insulator films 22 is 1 mm³.

Transduction efficiency $\eta$ is represented by equation (10). Microwave susceptibility $\chi_\mu$ in the equation (10) is represented by equation (11).

[Math. 4]

$$\eta = \left| \frac{\langle \hat{b}_{\text{out}} \rangle}{\langle \hat{a}_{\text{in}} \rangle} \right|^2$$

$$= \left| \frac{\sqrt{\kappa_{e,e}} \sqrt{\kappa_{o,e}} \left( \frac{\zeta_\beta g_\beta}{\chi_\alpha} + \frac{\zeta_\alpha g_\alpha}{\chi_\beta} \right)}{\frac{\zeta_\beta^2}{\chi_\alpha \chi_e} + \frac{\zeta_\alpha^2}{\chi_\beta \chi_e} + \frac{g_\beta^2}{\chi_\alpha \chi_o} + \frac{g_\alpha^2}{\chi_\beta \chi_o} + \frac{1}{\chi_\alpha \chi_\beta \chi_e \chi_o} + \zeta_\alpha^2 g_\beta^2 + \zeta_\beta^2 g_\alpha^2 - 2\zeta_\alpha \zeta_\beta g_\alpha g_\beta} \right|^2 \quad (10)$$

$$\chi_\mu = \left[ i(\omega - \omega_\mu) - \gamma_\mu/2 \right]^{-1} \quad (11)$$

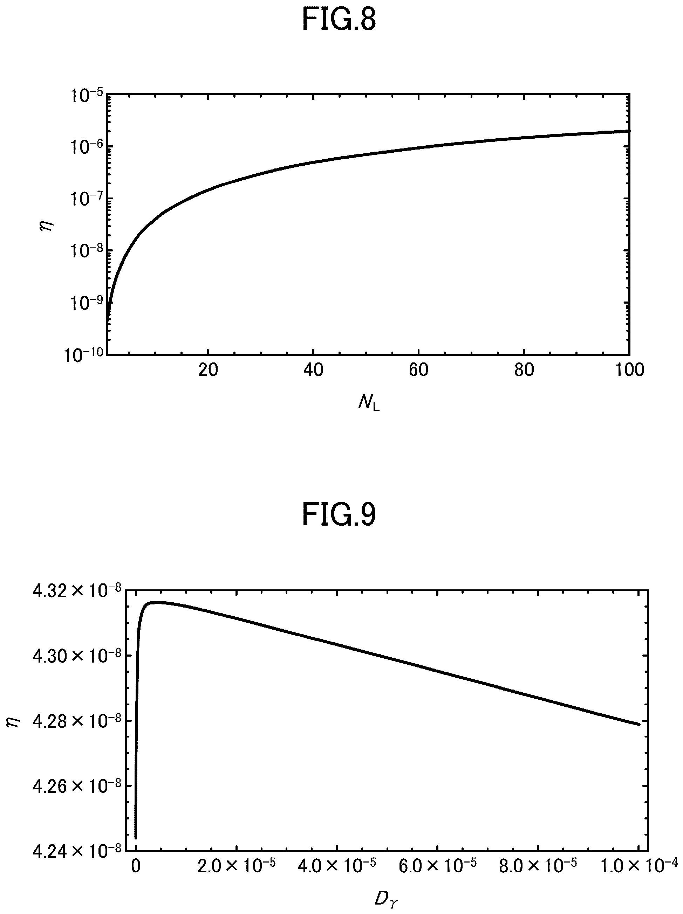

When resonance conditions are satisfied, that is, when the frequency $\omega$ of itinerant microwave photons, the resonant frequency $\omega_e$ of the microwave resonator 30, the resonant frequency $\omega_\mu$ of the antiferromagnetic insulators, and $\delta\omega_o$ are equal to one another, the transduction efficiency $\eta$ changes in accordance with the number $N_L$ of the second insulator films 22 as illustrated in FIG. 8. FIG. 8 is a graph illustrating the relationship between the number $N_L$ of the second insulator films 22 and the transduction efficiency $\eta$ according to the third embodiment. In this manner, the quantum transducer 300 can convert microwave photons of the microwave MW1 into optical photons. Further, in the quantum transducer 300, the transduction efficiency $\eta$ is proportional to the square of the number $N_L$ of the second insulator films 22. Therefore, the transduction efficiency $\eta$ is significantly increased as the number $N_L$ of the second insulator films 22 is increased. In FIG. 8, the thickness parameter $D_\gamma$ is 0.001, $\zeta_{0,\alpha}/2\pi$ and $\zeta_{0,\beta}/2\pi$ are about 1.5 kHz, $\gamma_\alpha/2\pi$ and $\gamma_\beta/2\pi$ are about 1,000 MHz, $g_{0,\alpha}/2\pi$ and $g_{0,\beta}/2\pi$ are about 600 MHz, $\kappa_{o,i}/2\pi$ and $\kappa_{o,e}/2\pi$ are about 100 MHz, and $\kappa_{e,i}/2\pi$ and $\kappa_{e,e}/2\pi$ are about 300 MHz.

Further, because the first insulator films 11 and the second insulator films 22 do not include topological insulators, light with a frequency of about 200 THz can be used. That is, light with low loss in optical fiber transmission can be used.

In a case where the number $N_L$ of the second insulator films 22 is constant, the relationship between the thickness parameter $D_\gamma$ and the transduction efficiency $\eta$ is as illustrated in FIG. 9. FIG. 9 is a graph illustrating the relationship between the thickness parameter $D_\gamma$ and the transduction efficiency $\eta$ according to the third embodiment. As illustrated in FIG. 9, in a range in which the thickness parameter $D_\gamma$ is greater than or equal to a certain threshold, the transduction efficiency $\eta$ increases as the thickness parameter $D_\gamma$ decreases. The thickness of each of the second insulator films 22 corresponding to the threshold of the thickness parameter $D_\gamma$ is about 1 nm. In FIG. 9, the number $N_L$ of the second insulator films 22 is 10, $\zeta_{0,\alpha}/2\pi$ and $\zeta_{0,\beta}/2\pi$ are about 1.5 kHz, $\gamma_\alpha/2\pi$ and $\gamma_\beta/2\pi$ are about 1,000 MHz, $g_{0,\alpha}/2\pi$ and $g_{0,\beta}/2\pi$ are about 600 MHz, $\kappa_{o,i}/2\pi$ and $\kappa_{o,e}/2\pi$ are about 100 MHz, and $\kappa_{o,i}/2\pi$ and $\kappa_{e,e}/2\pi$ are about 300 MHz.

(Fourth Embodiment)

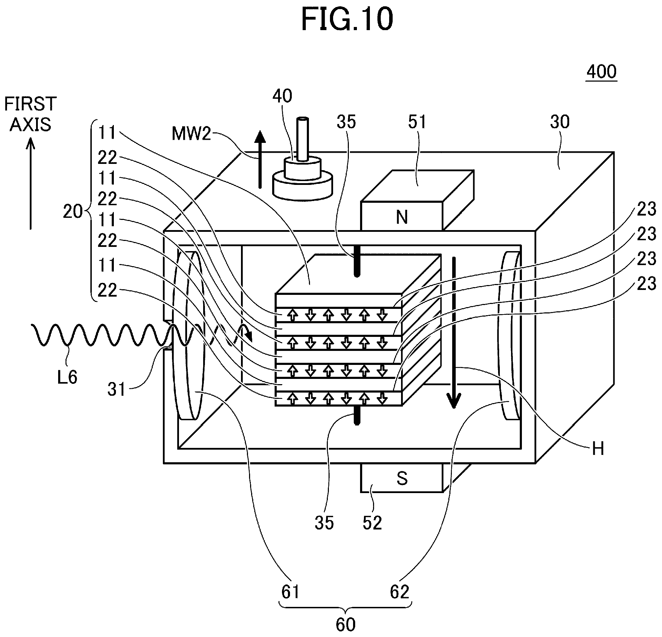

A fourth embodiment will be described. The fourth embodiment relates to a quantum transducer. The quantum transducer according to the fourth embodiment converts optical photons into microwave photons. FIG. 10 is a schematic view illustrating the quantum transducer according to the fourth embodiment.

As illustrated in FIG. 10, in a quantum transducer 400 according to the fourth embodiment, laser light L6 is emitted from the outside toward the stack 20 through the inlet 31. The outlet 32 is not necessarily provided. The laser light L6 includes linearly polarized laser light and circularly polarized laser light. The linearly polarized laser light and the circularly polarized laser light have components perpendicular to the easy axis of magnetization of the antiferromagnetic insulators included in the second insulator films 22.

The other configurations of the fourth embodiment are the same as those of the third embodiment.

In the fourth embodiment, a microwave MW2 corresponding to the polarization of the laser light L6 is emitted from the stack 20, and the antenna 40 outputs the microwave MW2 to the outside. In this manner, optical photons of the laser light L6 emitted to the stack 20 are converted into microwave photons of the microwave MW2. That is, a quantum transduction method using the quantum transducer 400 includes a process of emitting the laser light L6 to the stack 20 from a direction inclined with respect to the first axis. For example, optical photons with a frequency of about 200 THz are converted into microwave photons with frequencies of about 1 GHz to 100 GHz.

According to the fourth embodiment, the same effects as in the third embodiment can be obtained.

The quantum transducers according to the present disclosure can be used for communication between superconducting quantum bits (qubits) housed in a plurality of refrigerating machines, for example. However, the application of the quantum transducers according to the present disclosure is not limited to communication between superconducting qubits. Further, the quantum transducers can be used in quantum computing.

Although specific embodiments have been described above, the present invention is not limited to the above-described embodiments, and various modifications and substitutions can be made to the above-described embodiments without departing from the scope as defined in the claims.

**Claims**

1. A quantum transducer (100, 200, 300, 400) comprising:

    a three-dimensional cavity resonator (30);
    a stack (10, 20) disposed in the three-dimensional cavity resonator (30), including a nonmagnetic first insulator film (11) and a ferromagnetic or antiferromagnetic second insulator film (12, 22) that are stacked on each other, and having an interface between the first insulator film (11) and the second insulator film (12, 22);
    a magnetic field applicator (51, 52) configured to apply, to the stack (10, 20), a magnetic field having a component perpendicular to the interface; and
    a microwave transceiver (40) configured to transmit and receive a microwave to and from the stack (10, 20), wherein
    the first insulator film (11) and the second insulator film (12, 22) do not include a topological insulator,
    the second insulator film (12, 22) has an easy axis of magnetization along a first axis that is perpendicular to the interface, and
    laser light is emitted to the stack (10, 20) from a direction inclined with respect to the first axis.

2. The quantum transducer according to claim **1,** wherein the laser light is emitted to the stack (10, 20) from a direction perpendicular to the first axis.

3. The quantum transducer according to claim 1 or 2, further comprising:
    an optical resonator (60) disposed in the three-dimensional cavity resonator (30) and configured to resonate the laser light.

4. The quantum transducer according to any one of claims 1 to 3, wherein the three-dimensional cavity resonator (30) includes an inlet (31) through which the laser light is introduced from outside.

5. The quantum transducer according to claim 4, wherein the three-dimensional cavity resonator (30) includes an outlet (32) through which the laser light transmitted through the stack (10, 20) is guided to the outside.

6. The quantum transducer according to any one of claims 1 to 5, wherein the three-dimensional cavity resonator (30) is a microwave resonator.

7. The quantum transducer according to any one of claims 1 to 6, wherein the second insulator film (12) is a ferromagnetic insulator film.

8. The quantum transducer according to claim 7, wherein the second insulator film (12) includes $Y_3Fe_5O_{12}$, $Tm_3Fe_5O_{12}$, EuS, $Cr_2Ge_2Te_6$, $BaFe_{12}O_{19}$, or any combination thereof.

9. The quantum transducer according to any one of claims 1 to 6, wherein the second insulator film (22) is an antiferromagnetic insulator film.

10. The quantum transducer according to claim 9, wherein the second insulator film (22) includes $\alpha$-$Fe_2O_3$, $MnF_2$, $FeF_2$, NiO, or any combination thereof.

11. The quantum transducer according to any one of claims 1 to 10, wherein the first insulator film (11) includes $SrTiO_3$, $Al_2O_3$, or both.

12. A quantum transduction method using a quantum transducer (100, 200, 300, 400), the quantum transducer including

a three-dimensional cavity resonator (30), a stack (10, 20) disposed in the three-dimensional cavity resonator (30), including a nonmagnetic first insulator film (11) and a ferromagnetic or antiferromagnetic second insulator film (12, 22) that are stacked on each other, and having an interface between the first insulator film (11) and the second insulator film (12, 22),
a magnetic field applicator (51, 52) configured to apply, to the stack (10, 20), a magnetic field having a component perpendicular to the interface, and
a microwave transceiver (40) configured to transmit and receive a microwave to and from the stack (10, 20), wherein
the first insulator film (11) and the second insulator film (12, 22) do not include a topological insulator, and
the second insulator film (12, 22) has an easy axis of magnetization along a first axis that is perpendicular to the interface,
the quantum transduction method comprising:
emitting laser light to the stack (10, 20) from a direction inclined with respect to the first axis.

FIG.1

FIG.2

EP 4 693 117 A1

# FIG.3

# FIG.4

## FIG.5

# FIG.6

EP 4 693 117 A1

FIG.7

EP 4 693 117 A1

FIG.7

## FIG.8

## FIG.9

# FIG.10

400

FIRST
AXIS

MW2

11
22
11
22
11
22
11
22

20

40    35    51    30

N

23
23
23
23

L6

31

H

35    52

61    62

60

EP 4 693 117 A1

17

Europäisches
Patentamt
European
Patent Office
Office européen
des brevets

# EUROPEAN SEARCH REPORT

**Application Number**

EP 25 18 8024

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2024/150293 A1 (FUJITSU LTD [JP]) 18 July 2024 (2024-07-18) * figures 1, 5 * * paragraph [0011] - paragraph [0029] * ----- | 1-12 | INV. G06N10/40 |
| A | AKIHIKO SEKINE ET AL: "Microwave-to-Optical Quantum Transduction Utilizing the Topological Faraday Effect of Topological Insulator Heterostructures", ARXIV.ORG, CORNELL UNIVERSITY LIBRARY, 201 OLIN LIBRARY CORNELL UNIVERSITY ITHACA, NY 14853, 29 July 2024 (2024-07-29), XP091828735, * page 1 - page 5 * ----- | 1-12 | |
| A | HAOWEI XU ET AL: "Efficient Quantum Transduction Using Anti-Ferromagnetic Topological Insulators", ARXIV.ORG, CORNELL UNIVERSITY LIBRARY, 201 OLIN LIBRARY CORNELL UNIVERSITY ITHACA, NY 14853, 17 August 2023 (2023-08-17), XP091844699, DOI: 10.1103/PHYSREVB.110.085136 * page 1 - page 13 * ----- | 1-12 | **TECHNICAL FIELDS SEARCHED (IPC)** G06N G02F H04B |

The present search report has been drawn up for all claims

| Place of search | Date of completion of the search | Examiner |
|---|---|---|
| The Hague | 16 December 2025 | Bohn, Patrice |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 25 18 8024**

This annex lists the patent family members relating to the patent documents cited in  the above-mentioned European search report.
The members are as contained in the European Patent Office EDP file on
The European Patent Office is in no way liable for these particulars which are merely given for the purpose of information.

**16-12-2025**

| Patent document cited in search report | Publication date | Patent family member(s) | | Publication date |
|---|---|---|---|---|
| WO 2024150293  A1 | 18-07-2024 | EP | 4651040 A1 | 19-11-2025 |
| | | JP WO2024150293 A1 | | 18-07-2024 |
| | | WO | 2024150293 A1 | 18-07-2024 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023546863 A
- JP 2022538247 A
- US 20210114864
- US 20200412457